# EUROPÄISCHE PATENTSCHRIFT

(11) **EP 0 352 659 B1**
(45) Veröffentlichungstag und Bekanntmachung des Hinweises auf die Patenterteilung: **07.12.1994**
(21) Anmeldenummer: 89113459.5
(22) Anmeldetag: 21.07.1989
(51) Int. Cl.: H03K 17/08, G01R 31/02, G01R 19/165

(54) **Schaltungsanordnung zum Erfassen des Kurzschlusses einer mit einem FET in Reihe liegenden Last**
Circuit for determining shorts in a load in series with a FET
Circuit pour déterminer des court-circuits dans une charge en série avec un FET

(30) Priorität: 27.07.1988 DE 3825514
(43) Veröffentlichungstag der Anmeldung: 31.01.1990
(73) Patentinhaber: SIEMENS AKTIENGESELLSCHAFT, 80333 München (DE)
(72) Erfinder: Leipold, Ludwig, Dipl.-Ing., D-8000 München 40 (DE); Tihanyi, Jenö, Dr.-Ing., D-8000 München 70 (DE); Sander, Rainald, Dipl.-Phys., 8000 München 70 (DE); Weber, Roland, D-8000 München 40 (DE)

(56) Entgegenhaltungen:
- EP-A- 0 190 925
- WO-A-86/05926
- DE-A- 3 243 467
- PATENT ABSTRACTS OF JAPAN, Band 10, Nr. 283 (E-440)[2339], 26. September 1986 & JP-A-61 102 816

## Beschreibung

Die Erfindung bezieht sich auf eine Schaltungsanordnung zum Erfassen des Kurzschlusses einer mit einem Leistungs-MOSFET in Reihe liegenden Last durch einen der Drain-Sourcestrecke des Leistungs-MOSFET parallel geschalteten Spannungsvergleicher, der beim Übersteigen einer vorgegebenen, für den Kurzschluß der Last charakteristischen Spannung ein Signal abgibt. Beim Einsatz von Leistungs-IC z.B. in komplexen Bordnetzen von Kraftfahrzeugen kann es aus verschiedenen Gründen zur Überbrückung der Last und damit zum Kurzschluß kommen. Der Leistungs-MOSFET wird dabei mit einer Kurzschlußleistung in der Größenordnung von einigen kW belastet. Die bekannte Erfassung einer Überlast durch Erfassen der Temperaturen des Leistungs-MOSFET ist im Kurzschlußfall wenig wirksam, da sie vergleichsweise träge arbeitet und der MOSFET in der Zeit bis zum Ansprechen der Abschaltelektronik bereits zerstört sein kann. Eine Schaltungsanordnung gemäß dem oben angegebenen Gattungsbegriff ist z.B. in der EP 0 190 925 A2 beschrieben worden. Dieser enthält im Spannungsvergleicher neben einer Zenerdiode Widerstände. Die Spannungserhöhung an Widerständen ist jedoch lediglich dem Strom proportional.

Der Erfindung liegt die Aufgabe zugrunde, eine Schaltungsanordnung gemäß dem obengenannten Gattungsbegriff weiterzubilden.

Dieses Ziel wird erreicht durch die Merkmale des Anspruches 1: Der Spannungsvergleicher enthält eine der Drain-Sourcestrecke des Leistungs-MOSFET parallel geschaltete Reihenschaltung eines Bauelements mit Zenercharakteristik und eines als Depletion-MOSFET ausgebildeten zweiten MOSFET, dessen Gateanschluß mit seinem Sourceanschluß verbunden ist; der Drainanschluß des zweiten MOSFET ist mit dem Drainanschluß des Leistungs-MOSFET und dem Sourceanschluß eines dritten MOSFET verbunden; der dritte MOSFET ist von dem Leistungs-MOSFET entgegengesetzten Kanaltyp; der Source Anschluß des zweiten MOSFET ist mit dem Gateanschluß des dritten MOSFET, mit einem Anschluß des Bauelements mit Zenercharakteristik und mit einem Anschluß (10) der versorgungsspannung verbunden; das Signal für den Kurzschlußfall wird am Drainanschluß des dritten MOSFET abgegeben.

In der Anmeldung WO 86/05926 ist zwar ein Spannungsvergleicher beschrieben, in dem eine Stromquelle vorgesehen ist. Die Stromquelle ist jedoch kein MOSFET und liegt auch nicht mit einem Bauelement mit Zenercharakteristik in Reihe. Außerdem ist die hier beschriebene Spannungsvergleicherschaltung nicht der Drain-Sourcestrecke des Leistungs-MOSFET parallel gechaltet.

Weiterbildungen der Erfindung sind Gegenstand der abhängigen Ansprüche.

Die Erfindung wird anhand eines Ausführungsbeispiels in Verbindung mit den Figuren 1 bis 3 näher erläutert. Es zeigen:
- Figur 1: das Prinzip einer Schaltungsanordnung zum Erfassen des Kurzschlusses,
- Figur 2: den prinzipiellen Aufbau des Spannungsvergleichers nach Figur 3,
- FIG 3: die erfindungsgemäße Realisierung des Ausführungsbeispiels nach FIG 2 mit integrationsfähigen Komponenten.

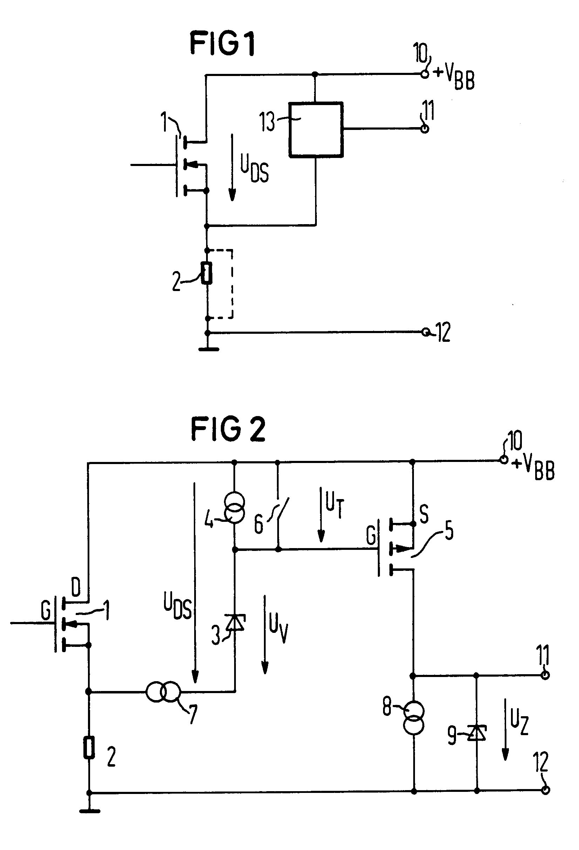

Die Schaltungsanordnung nach FIG 1 zeigt einen Leistungs-MOSFET 1, dem sourceseitig eine Last 2 in Reihe geschaltet ist. Die Reihenschaltung liegt über Klemmen 10, 12 an einer Versorgungsspannung V_{BB}. Wird die Last, wie durch die gestrichelte Verbindung zwischen ihren Anschlußklemmen angedeutet, kurzgeschlossen, so fließt ein hoher Strom durch den Leistungs-MOSFET 1. Damit steigt die am MOSFET liegende Sourcespannung U_{DS} auf einen Wert nahe der Versorgungsspannung an. Da hierbei ein hoher Strom, nämlich der Kurzschlußstrom, durch den Transistor fließt, würde er innerhalb kürzester Zeit zerstört. Der Drain-Sourcestrecke des MOSFET 1 ist ein Spannungsvergleicher 13 parallel geschaltet, dessen Referenzspannung auf einen Wert eingestellt ist, der für den Transistor noch ungefährlich ist, jedoch im Kurzschlußfall überstiegen wird. Eine solche Spannung ist für einen Leistungs-MOSFET z.B. 6 Volt. Tritt also der Kurzschlußfall ein, so steigt die Spannung am Transistor steil gegen die Versorgungsspannung an. Bei Erreichen einer Spannung U_{DS} von z.B. 6 V gibt der Spannungsvergleicher 13 eine Referenzspannung ab, die an seinem Ausgang 11 als Signal für den Kurzschluß detektiert werden kann. Diese Spannung wird dann in einer nicht gezeigten, logische Signale verarbeitenden Schaltungsanordnung dazu benutzt, den Leistungs-MOSFET 1 abzuschalten.

In FIG 2 ist dargestellt, wie der Spannungsvergleicher 13 prinzipell aufgebaut ist. Er enthält eine Zenerdiode 3, der eine Stromquelle 4 in Reihe geschaltet ist. Ein Anschluß der Stromquelle 4 ist einerseits mit dem Drainanschluß D des MOSFET 1 und andererseits mit der Klemme 10 verbunden. Der andere Anschluß der Stromquelle 4 ist mit der Zenerdiode 3 und mit dem Gateanschluß G eines zweiten MOSFET 5 verbunden. Der MOSFET 5 ist von dem Leistungs-MOSFET 1 entgegengesetzten Kanaltyp. Im Ausführungsbeispiel ist 1 ein n-Kanal-MOSFET und 5 ist ein p-Kanal-MOSFET. Der Sourceanschluß S ist mit dem Drainanschluß des MOSFET 1 verbunden, sein Drainanschluß D liegt über eine Last 8 an der anderen Klemme 12.

Im Normalbetrieb ist U_{DS} so klein, daß der Spannungsvergleicher kein Signal abgibt. In diesem Fall liegt der Gateanschluß G des MOSFET 5 über die Stromquelle 4 praktisch auf dem Potential V_{BB}. Er ist damit gesperrt. Übersteigt die Spannung U_{DS} am MOSFET 1 die Summe der Zenerspannungen der Zenerdiode 3 und der Einsatzspannung U_{T} des FET 5, so wird der MOSFET 5 leitend gesteuert. Damit fließt ein Strom von der Klemme 10 durch den MOSFET 5 und die Last 8 zur Klemme 12. Die an der Last 8 abfallende Spannung kann an den Klemmen 11, 12 als Signal für den Kurzschlußfall detektiert und in ein Signal umgewandelt werden, das den Leistungs-MOSFET 1 abschaltet.

Die Last 8 kann ein Widerstand oder auch eine Stromquelle sein, die sich in integrierter Form besonders leicht realisieren läßt. Zur Begrenzung der Spannung liegt zwischen den Ausgangsklemmen 11 und 12 eine Zenerdiode 9. Wird der MOSFET 5 leitend gesteuert, so wird die Ausgangsspannung auf die Zenerspannung U_{Z} begrenzt.

Wird die Schaltungsanordnung im Ruhezustand nicht extern abgeschaltet, so liegt sie ständig an der Versorgungsspannung V_{BB}. Im gesperrten Zustand des Leistungs-MOSFET 1 würde damit ständig ein Strom durch den MOSFET 5 fließen. Dieser Strom läßt sich zwar durch geeignete Dimensionierung der die Last 8 bildenden Stromquelle z.B. auf einige µA begrenzen, es würde aber dauernd Kurzschluß signalisiert. Für diesen Fall, wird zwischen Gateanschluß G und Sourceanschluß S des MOSFET 5 ein Schalter 6 gelegt, der im gesperrten Zustand des Leistungs-MOSFET 1 geschlossen ist. Zur Begrenzung des über den Schalter 6 fließenden Stroms ist zwischen Sourceanschluß des MOSFET 1 und der Zenerdiode 3 oder zwischen der Zenerdiode 3 und dem Verbindungspunkt zwischen Stromquelle 4 und Zenerdiode 3 eine weitere Stromquelle 7 vorgesehen. Diese begrenzt den über den Schalter 6, die Zenerdiode 3 und die Last 2 fließenden Strom auf z. B. 5 µA. Wird der MOSFET 1 leitend gesteuert, so wird der Schalter 6 z.B. über eine Logikschaltung geöffnet.

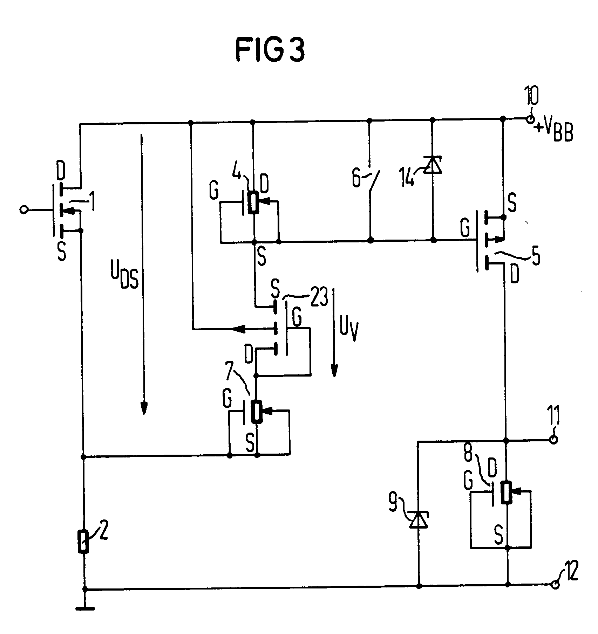

In FIG 3 ist die Realisierung der Stromquellen 4, 7 und 8 gezeigt. Die Stromquellen bestehen aus n-Kanal Depletion-MOSFET, deren Gateanschluß G jeweils mit ihrem Sourceanschluß S elektrisch verbunden sind. Die Zenerdiode 3 ist durch einen p-Kanal Enhancement-MOSFET 23 ersetzt, dessen Sourceanschluß S mit dem Sourceanschluß der Stromquelle 4 und deren Drainanschluß mit dem Drainanschluß der Stromquelle 7 verbunden ist. Der Gateanschluß von 23 ist mit seinem Drainanschluß verbunden. Der MOSFET 23 wirkt hier als MOS-Diode mit Zenercharakteristik. Das Substrat des MOSFET 23 kann in integrierter Form mit dem Drainanschluß von 1, diskret aufgebaut mit dem Sourceanschluß von 3 verbunden sein.

Zum Schutz der Gate-Sourcekapazität von 5 ist dieser eine Zenerdiode 14 parallel geschaltet.

## Patentansprüche

1. Schaltungsanordnung zum Erfassen des Kurzschlusses einer mit einem Leistungs-MOSFET (1) und einer Versorgungsspannung (V_{BB}) in Reihe liegenden Last (2) durch einen der Drain-Sourcestrecke des Leistungs-MOSFET (1) parallel geschalteten Spannungsvergleicher, der beim Übersteigen einer vorgegebenen, für den Kurzschluß der Last charakteristischen Spannung ein Signal abgibt,
**gekennzeichnet durch** die Merkmale:
a) Der Spannungsvergleicher enthält eine der Drain-Sourcestrecke des Leistungs-MOSFET parallel geschaltete Reihenschaltung eines Bauelements (3,23) mit Zenercharakteristik und eines als Depletion-MOSFET ausgebildeten zweiten MOSFET (4), dessen Gateanschluß mit seinem Sourceanschluß verbunden ist,
b) der Drainanschluß des zweiten MOSFET ist mit dem Drainanschluß des Leistungs-MOSFET, dem Sourceanschluß eines dritten MOSFET (5) und einem Ansschluß (10) der Versorgungsspannung verbunden,
c) der dritte MOSFET ist von dem Leistungs-MOSFET entgegengesetzten Kanaltyp,
d) der Source-Anschluß des zweiten MOSFET ist mit dem Gateanschluß des dritten MOSFET und mit einem Anschluß des Bauelements mit Zenercharakteristik verbunden,
e) das Signal für den Kurzschlußfall wird am Drainanschluß (11) des dritten MOSFET abgegeben.

2. Schaltungsanordnung nach Anspruch 1,
**dadurch gekennzeichnet**, daß dem dritten MOSFET drainseitig eine zweite Last (8) in Reihe geschaltet ist und daß die an der zweiten Last abfallende Spannung an einem Paar von Ausgangsklemmen (11, 12) anliegt.

3. Schaltungsanordnung nach Anspruch 1 oder 2
**dadurch gekennzeichnet** daß zwischen Gate- und Sourceanschluß des zweiten MOSFET (4) ein Schalter (6) liegt, der dann leitend ist, wenn der Leistungs-MOSFET gesperrt ist und daß zwischen Sourceanschluß des Leistungs-MOSFET und dem Bauelement oder zwischen dem Bauelement und dem Gateanschluß des zweiten MOSFET ein vierter, als Depletion-MOSFET ausgebildeter Transistor (7) liegt, dessen Gateanschluß mit seinem Sourceanschluß verbunden ist.

4. Schaltungsanordnung nach Anspruch 2 oder 3,
**dadurch gekennzeichnet**, daß die zweite Last (8) durch einen fünften, als Depletion-MOSFET ausgebildeten MOSFET (8) gebildet ist, dessen Gateanschluß mit seinem Sourceanschluß verbunden ist.

5. Schaltungsanordnung nach Anspruch 4,
**dadurch gekennzeichnet**, daß dem fünften MOSFET (8) eine Zenerdiode (9) parallel geschaltet ist.

6. Schaltungsanordnung nach Anspruch 1,
**dadurch gekennzeichnet**, daß das Bauelement (3) ein Enhancement-MOSFET ist, dessen Gateanschluß mit dem Drainanschluß verbunden und dessen Sourceanschluß mit dem als Stromquelle geschalteten zweiten MOSFET (4) verbunden ist.

7. Schaltungsanordnung nach Anspruch 1,
**dadurch gekennzeichnet**, daß das Bauelement eine Zenerdiode ist.

## Claims

1. Circuit arrangement for detecting the short-circuiting of a load (2) connected in series with a power MOSFET (1) and a supply voltage (V_{BB}) by means of a voltage comparator which is connected in parallel with the drain-source junction of the power MOSFET (1) and which emits a signal upon the overshooting of a prescribed voltage characteristic of the short-circuiting of the load, characterized by the features:
a) the voltage comparator contains a series circuit connected in parallel to the drain-source junction of the power MOSFET and composed of a component (3, 23) with a zener characteristic and of a second MOSFET (4), which is constructed as a depletion MOSFET and whose gate terminal is connected to its source terminal,
b) the drain terminal of the second MOSFET is connected to the drain terminal of the power MOSFET, the source terminal of a third MOSFET (5) and a terminal (10) of the supply voltage,
c) the third MOSFET is of the channel type opposed to the power MOSFET,
d) the source terminal of the second MOSFET is connected to the gate terminal of the third MOSFET and to a terminal of the component with a zener characteristic,
e) the signal for the short-circuiting case is emitted at the drain terminal (11) of the third MOSFET.

2. Circuit arrangement according to Claim 1, characterized in that on the drain side a second load (8) is connected in series with the third MOSFET, and in that the voltage dropping across the second load is applied to a pair of output terminals (11, 12).

3. Circuit arrangement according to Claim 1 or 2, characterized in that situated between the gate and source terminals of the second MOSFET (4) is a switch (6) which is conductive when the power MOSFET is blocked, and in that situated between the source terminal of the power MOSFET and the component, or between the component and the gate terminal of the second MOSFET, is a fourth transistor (7), which is constructed as a depletion MOSFET and whose gate terminal is connected to its source terminal.

4. Circuit arrangement according to Claim 2 or 3, characterized in that the second load (8) is formed by a fifth MOSFET (8), which is constructed as a depletion MOSFET and whose gate terminal is connected to its source terminal.

5. Circuit arrangement according to Claim 4, characterized in that a zener diode (9) is connected in parallel with the fifth MOSFET (8).

6. Circuit arrangement according to Claim 1, characterized in that the component (3) is an enhancement MOSFET whose gate terminal is connected to the drain terminal and whose source terminal is connected to the second MOSFET (4), which is connected as a current source.

7. Circuit arrangement according to Claim 1, characterized in that the component is a zener diode.

## Revendications

1. Montage pour détecter le court-circuit d'une charge (2) branchée en série avec un transistor MOSFET de puissance (1) et une tension d'alimentation (V_{BB}), au moyen d'un comparateur de tension qui est branché en parallèle avec la voie drain-source du transistor MOSFET de puissance (1) et qui délivre un signal lors du dépassement d'une tension prédéterminée, caractéristique du court-circuit de la charge, caractérisé par les particularités suivantes :
a) le comparateur de tension contient un montage en série, branché en parallèle avec la voie drain-source du transistor MOSFET de puissance et formé d'un composant (3,23) possédant une caractéristique de Zener et un second transistor MOSFET (4) réalisé sous la forme d'un transistor MOSFET à appauvrissement et dont la borne de grille est reliée à sa borne de source,
b) la borne de drain du second transistor MOSFET est reliée à la borne de drain du transistor MOSFET de puissance, à la borne de source d'un troisième transistor MOSFET (5) et à une borne (10) de la tension d'alimentation,
c) le troisième transistor MOSFET possède un canal du type opposé à celui du transistor MOSFET de puissance,
d) la borne de source du second transistor MOSFET est reliée à la borne de grille du troisième transistor MOSFET et à une borne du composant présentant une caractéristique de Zener,
e) le signal pour le cas du court-circuit est délivré au niveau de la borne de drain (11) du troisième transistor MOSFET.

2. Montage suivant la revendication 1, caractérisé par le fait qu'une seconde charge (8) est branchée en série avec le troisième transistor MOSFET, côté drain, et que la tension, qui chute dans la seconde charge, est appliquée à un couple de bornes de sortie (11,12).

3. Montage suivant la revendication 1 ou 2, caractérisé par le fait qu'entre la borne de grille et la borne de source du second transistor MOSFET (1) est branché un interrupteur (6), qui est conducteur lorsque le transistor MOSFET de puissance est bloqué, et qu'entre la borne de source du transistor MOSFET de puissance et le composant ou entre le composant et la borne de grille du second transistor MOSFET est branché un quatrième transistor (7) réalisé sous la forme d'un transistor MOSFET à appauvrissement, dont la borne de grille est raccordée à sa borne de source.

4. Montage suivant la revendication 2 ou 3, caractérisé par le fait que la seconde charge (8) est formée par un cinquième transistor MOSFET (8) réalisé sous la forme d'un transistor MOSFET à appauvrissement et dont la borne de grille est raccordée à sa borne de source.

5. Montage suivant la revendication 4, caractérisé par le fait qu'une diode Zener (9) est branchée en parallèle avec le cinquième transistor MOSFET (8).

6. Montage suivant la revendication 1, caractérisé par le fait que le composant (3) est un transistor MOSFET à enrichissement, dont la borne de grille est reliée à la borne de drain et dont la borne de source est reliée au second transistor MOSFET (4) branché en tant que source de courant.

7. Montage suivant la revendication 1, caractérisé par le fait que le composant est une diode Zener.
